Europäisches Patentamt

European Patent Office

Office européen des brevets

(19)

(11) EP 0 483 449 B1

(12) **EUROPÄISCHE PATENTSCHRIFT**

(45) Veröffentlichungstag und Bekanntmachung des Hinweises auf die Patenterteilung:
**28.02.1996 Patentblatt 1996/09**

(51) Int Cl.[6]: **H03K 17/60**, H03K 17/08

(21) Anmeldenummer: **91106093.7**

(22) Anmeldetag: **17.04.1991**

(54) **Als Bauteil ausgebildete Schaltungsanordnung mit mindestens einem Halbleiterschalter zum Schalten einer Last**

Circuit arrangement formed as a component with at least one semiconductor switch for switching a load

Circuit fabriqué en forme d'un composant avec au moins un commutateur à semi-conducteur pour commuter une charge

(84) Benannte Vertragsstaaten:
**DE**

(30) Priorität: **31.10.1990 DE 4034571**

(43) Veröffentlichungstag der Anmeldung:
**06.05.1992 Patentblatt 1992/19**

(73) Patentinhaber: **VDO Adolf Schindling AG
D-60487 Frankfurt (DE)**

(72) Erfinder:
- **Blümel, Thomas
  W-6384 Schmitten 1 (DE)**
- **Lukas, Bernhard
  W-6096 Raunheim (DE)**
- **Meicher, Joachim
  W-6238 Hofheim (DE)**
- **Kares, Walter
  W-6000 Frankfurt 60 (DE)**

(74) Vertreter: **Klein, Thomas, Dipl.-Ing. (FH)
D-65824 Schwalbach/Ts. (DE)**

(56) Entgegenhaltungen:
**US-A- 4 707 620**

- **PATENT ABSTRACTS OF JAPAN, Bd. 10, Nr. 297 (E-444)(2353) 9. Oktober 1986 & JP-A-61112424**
- **ELEKTRONIK, Bd. 37, Nr. 10, 13. Mai 1988, SS. 89-92,95,96,98, München, DE; M. LEE: "Zuverlässig und sicher schalten"**
- **ELEKTRONIK, Bd. 39, Nr. 6, 16. März 1990, SS. 92-97, München, DE; E. HABEKOTTE et al.: "Integrierbare Funktionsblöcke"**
- **PESC 88 RECORD - 19TH ANNUAL IEEE POWER ELECTRONICS SPECIALISTS CONFERENCE Band 2, 11-14 April 1988, Seiten 1319-1324, Doshisha University, Kyoto, JP; J.G. MANSMANN et al.: "ASIC like HVIC for Interfacing to Half-Bridge Based Power Circuits"**
- **EDN - Electrical Design News, Bd. 33, Nr. 7, 31. März 1988, SS. 113-120,122,124,126, Newton, MA, US; D. PRYCE: "Smart-power"**

EP 0 483 449 B1

## Beschreibung

Als Baustein ausgebildete Schaltungsanordnung mit mindestens einem Halbleiterschalter zum Schalten einer Last

Die Erfindung betrifft eine als Baustein ausgebildete Schaltungsanordnung mit mindestens einem Halbleiterschalter zum Schalten einer Last, insbesondere eines Stellgliedes in Steuerungs- oder Regeleinrichtungen, bei welcher ein Umschalteingang vorgesehen is, wobei die Schaltungsanordnung in Abhängigkeit von einer dem Umschalteingang zuführbaren Umschaltspannung Schaltungsanordnung an verschiedene, vorzugsweise zwei verschiedene Lastbereiche angepaßt ist.

Steuerungs- oder Regeleinrichtungen werden häufig aus einzelnen Bausteinen zusammengesetzt, die meistens als integrierte Schaltungen ausgebildet sind. Dazu sind beispielsweise sogenannte Treiber-Bausteine bekannt, in denen sich eine oder mehrere Endstufen zum Schalten von Lasten befinden. Ein solcher Treiberbaustein, welcher verschiedene Diagnosemöglichkeiten für Strom-, Temperatur- und Spannungsüberlastung aufweist, ist in ELEKTRONIK, Mai 1988, S. 89-98 beschrieben. In elektronischen Systemen für Kraftfahrzeuge werden derartige Treiber-Bausteine beispielsweise zum Schalten von Einspritzventilen, für die Tankregenerierung und für die Abgasrückführung angewendet.

Die jeweils zu schaltenden Lasten haben jedoch verschiedene Eigenschaften, insbesondere bezüglich ihres Widerstandes, also ihres Leistungsbedarfs, und ihrer Induktivität. Für ein optimales Zusammenwirken des jeweiligen Treiber-Bausteins mit den verschiedenen Lasten ist daher der Einsatz verschieden ausgelegter Treiber-Bausteine erforderlich. Damit ist eine Verteuerung der Steuerungs- und Regeleinrichtungen verbunden, da die einzelnen Typen oder Treiber-Bausteine in geringeren Stückzahlen gefertigt werden und die Logistik bei einer größeren Typenvielfalt aufwendiger wird.

Gemäß JP-A-61-112424 ist eine Schaltungsanordnung bekannt, die zwei Halbleiterschalter zum Schalten einer Last enthält, bei der ein Umschalteingang vorgesehen ist und bei der in Abhängigkeit von einer Umschaltspannung, über die wahlweise einer oder beide der Halbleiterschalter leitend gesteuert werden, die Schaltungsanordnung an zwei verschiedene Lastbereiche angepaßt ist.

Aufgabe der erfindungsgemäßen Schaltungsanordnung ist es, die Verwendung eines einheitlichen Treiber-Bausteins für mehrere Lastbereiche zu ermöglichen.

Die erfindungsgemäße Schaltungsanordnung ist dadurch gekennzeichnet, daß Schwellwerte, bei denen eine Kurzschluß-Überwachungsschaltung und eine Leerlauf-Überwachungsschaltung ansprechen, von der Umschaltspannung abhängig sind.

Eine Weiterbildung der Erfindung besteht darin, daß die Amplitude eines Steuersignals, das der Steuerelektrode des Halbleiterschalters zuführbar ist, von der Umschaltspannung abhängig ist. Dadurch wird ermöglicht, daß in einem oberen Lastbereich ein genügend großer Basisstrom zur Ansteuerung des als Transistor ausgeführten Halbleiterschalters zur Verfügung steht, um den Transistor sicher durchzuschalten, und daß in einem unteren Lastbereich nicht unnötig viel Basisstrom fließt. Durch Letzteres wird im unteren Lastbereich die Leistungsaufnahme auf das notwendige Maße reduziert.

Für Sicherheits- und Fehlerdiagnosezwecke können in den Treiber-Baustein Überwachungsschaltungen integriert werden. So werden beispielsweise bei verschiedenen Schwellwerten für den Strom durch den Halbleiterschalter Kurzschluß- oder Leerlauf-Fehlermeldunen ausgegeben. Die Schwellwerte liegen dabei außerhalb des Strombereichs bei ordnungsgemäßem Betrieb, wobei Toleranzen und zeitliche sowie thermische Änderungen der Last zu berücksichtigen sind. Die Schwellwerte sollten jedoch nicht zu weit von den Grenzen dieses Strombereichs entfernt liegen, damit abnorme Betriebszustände, die noch keinen vollständigen Kurzschluß oder Leerlauf darstellen, ebenfalls angezeigt werden.

Zum Schutz des Halbleiterschalters gegen Überspannungen beim Schalten von induktiven Lasten ist eine Z-Diode vorgesehen. Da bei verschiedenen Lasten auch verschieden hohe Spannungsspitzen zuzulassen sind, ist gemäß einer anderen Weiterbildung vorgesehen, daß eine Begrenzung der Spannung am Halbleiterschalter von der Umschaltspannung abhängig ist.

Eine andere Weiterbildung trägt dazu bei, mit der erfindungsgemäßen Schaltungsanordnung dadurch eine möglichst aussagefähige Fehlerdiagnose durchzuführen, daß für jeweils einen Halbleiterschalter eine Kurzschluß-Überwachungsschaltung mit je einem Ausgangsanschluß vorgesehen sind.

Durch die in weiteren Unteransprüchen aufgeführten Maßnahmen sind weitere vorteilhafte Weiterbildungen und Verbesserungen der im Hauptanspruch angegebenen Erfindung möglich.

Die Erfindung läßt zahlreiche Ausführungsformen zu. Eine davon ist schematisch in der Zeichnung anhand mehrerer Figuren dargestellt und nachfolgend beschrieben. Es zeigt:

Fig. 1    ein Blockschaltbild des Ausführungsbeispiels und

Fig. 2    ein Blockschaltbild einer Steuereinrichtung mit einer erfindungsgemäßen Schaltungsanordnung.

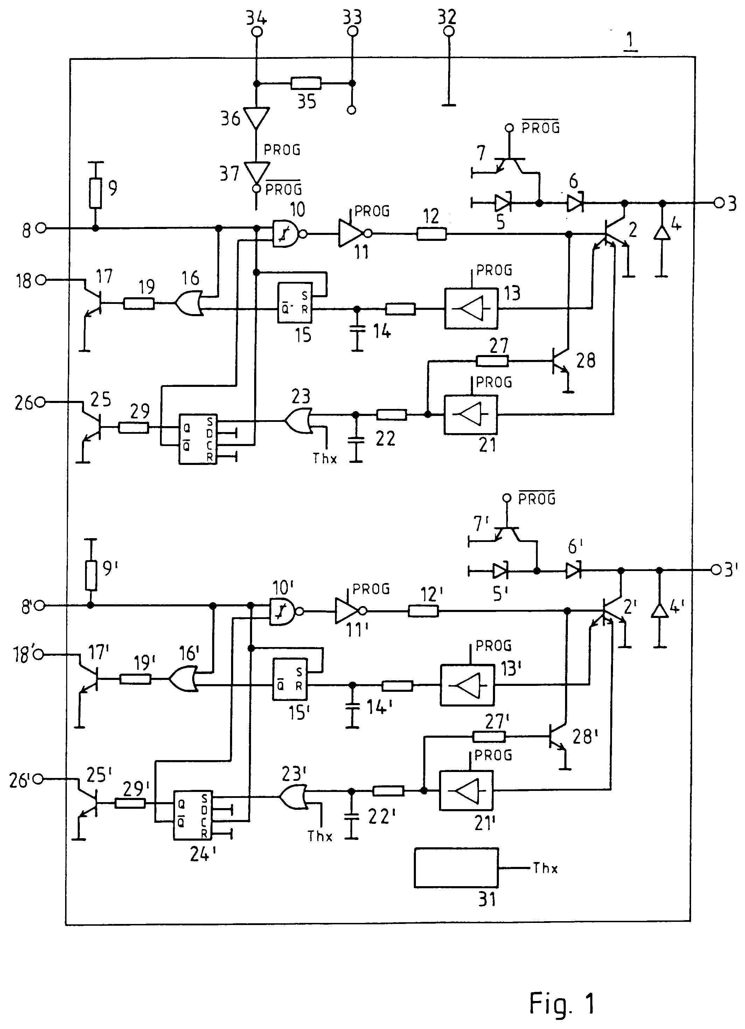

Gleiche Teile sind in den Figuren mit gleichen Bezugszeichen versehen. Der in Fig. 1 dargestellte Baustein 1 enthält zwei identische Schaltungen mit je einem Halbleiterschalter, der als Endstufe (Treiber) beispielsweise für verschiedene Stellglieder in einem Kraftfahrzeug geeignet ist und dem Halbleiter jeweils zugeordnete Schaltungen. Im folgenden wird daher nur die Schal-

tung mit den Bezugzeichen 2 bis 29 beschrieben, während die Elemente der anderen Schaltung mit den Bezugszeichen 2' bis 29' versehen sind.

Die Endstufe wird von einem Multi-Emitter-Transistor 2 gebildet, dessen einer Emitter mit Masse und dessen Kollektor mit einem Ausgang 3 verbunden ist. Da die Schaltungsanordnung im wesentlichen zum Schalten von induktiven Verbrauchern vorgesehen ist, sind dem Transistor 2 eine Verpolschutzdiode 4 und Freilaufdioden 5, 6 parallelgeschaltet, wobei die in Reihe geschalteten Z-Dioden 5, 6 ferner einen Schutz des Transistors 2 vor Überspannungen bewirken. Durch Überbrücken der Z-Diode 5 mit Hilfe eines Transistors 7 kann die Begrenzungsspannung herabgesetzt werden.

Ein Steuersignal für den Transistor 2 wird über einen Eingang 8 zugeführt, der über einen Eingangswiderstand 9 mit Masse verbunden ist. Das Steuersignal gelangt über eine Nicht-Und-Schaltung 10, einen invertierenden Verstärker 11, dessen Verstärkungsgrad einstellbar ist, und einen Widerstand 12 zur Basis des Transistors 2.

Zum Erkennen von Fehlern im Bereich des Ausgangs 3 sind eine Leerlauf-Überwachungsschaltung und eine Kurzschluß-Überwachungsschaltung vorgesehen. Die Leerlauf-Überwachungsschaltung spricht an, wenn der Strom durch den Transistor 2 unterhalb einer vorgegebenen Schwelle liegt, wenn also eine Leitungsunterbrechung zwischen dem Kollektor des Transistors 2, dem Verbraucher, innerhalb des Verbrauchers oder zwischen dem Verbraucher und der positiven Betriebsspannung vorliegt. Außerdem reagiert die Leerlauf-Überwachungsschaltung bei einem Kurzschluß des Ausgangs 3 gegen Masse.

Die Kurzschluß-Überwachungsschaltung spricht an, wenn der Strom durch den Transistor 2 einen weiteren vorgegebenen Wert überschreitet, was im wesentlichen bei einem Schluß zwischen dem Ausgang 3 oder der Leitung zum Verbraucher einerseits und dem positiven Pol der Betriebsspannungsquelle andererseits der Fall ist.

Die Leerlauf-Überwachungsschaltung wird von einer Schwellwertschaltung 13, einem Tiefpaß 14, einem Flip-Flop 15, einer Oder-Schaltung 16 und einem Ausgangs-Transistor 17 gebildet. An einem Ausgang 18 ist ein Signal entnehmbar, welches einen Leerlauf, also beispielsweise einen Leitungsbruch, anzeigt.

Die Schwellwertschaltung 13 erzeugt ein Ausgangssignal, das bei Überschreiten eines vorgegebenen Wertes des Stroms durch den Transistor 2 positiv wird. Dieser vorgegebene Wert liegt unterhalb des für den jeweiligen Verbraucher zu erwartenden Stroms, wobei Toleranzen der einzelnen Verbraucher und zeitliche und thermische Schwankungen zu berücksichtigen sind. Mit dem Tiefpaß 14, der beispielsweise eine Zeitkonstante von 200 µs aufweist, werden kurzzeitige Störungen unterdrückt.

Das Flip-Flop 15 wird mit Beginn jeweils eines den Transistor 2 in den leitenden Zustand steuernden Steuerimpulses gesetzt. Am Ausgang $\overline{Q}$ steht dann der Wert L an. Durch die Oder-Verknüpfung 16 mit dem Steuersignal, das zu dieser Zeit den Wert H aufweist, entsteht am Ausgang der Oder-Schaltung ebenfalls ein positives Signal (H), das über den Widerstand 19 den Transistor 17 in leitenden Zustand steuert. Der Ausgang 18 erhält damit den Pegel L.

Steigt während der leitenden Phase des Transistors 2 der Strom über den Schwellwert, was bei störungsfreiem Betrieb auch bei induktiven Verbrauchern der Fall ist, wird das Flip-Flop 15 zurückgesetzt. Am Ende der leitenden Phase nimmt das Steuersignal den Wert L an, so daß wegen der Oder-Verknüpfung bei 16 das Signal am Ausgang 18 vom Pegel am Ausgang $\overline{Q}$ abhängig ist. Da das Flip-Flop 15 zurückgesetzt worden ist, liegt am Ausgang $\overline{Q}$ der Pegel H an, so daß der Transistor 17 weiterhin leitend ist und am Ausgang 18 der Pegel L herrscht.

Hat jedoch der Strom durch den Transistor 2 während der leitenden Phase nicht den vorgegebenen Wert überschritten, bleibt das Flip-Flop 15 gesetzt, so daß der Ausgang $\overline{Q}$ weiterhin den Pegel L führt. Dieses führt zu einem Sperren des Transistors 17, so daß am Ausgang 18 der Pegel H als Fehlermeldung ausgegeben wird.

Die Kurzschluß-Überwachungsschaltung besteht aus einer Schwellwertschaltung 21, einem Tiefpaß 22, einer Oder-Schaltung 23, einem Flip-Flop 24 und einem Ausgangs-Transistor 25, dessen Kollektor einen Ausgang 26 bildet. Das Ausgangssignal der Schwellwertschaltung 21 springt auf einen positiven Wert, wenn der Strom durch den Transistor 2 einen Wert übersteigt, der oberhalb der beim normalen Betrieb zu erwartenden Ströme liegt. Der Tiefpaß 2 dient zur Unterdrückung von kurzzeitigen Störungen. Um einer Überlastung des Transistors 2 möglichst schnell zu begegnen, ist an den Ausgang der Schwellwertschaltung 21 über einen Widerstand 27 die Basis eines Transistors 28 angeschlossen, der die Basis des Transistors 2 im Kurzschlußfall mit Masse verbindet und somit eine weitere Ansteuerung verhindert. Dadurch wird der Strom auf einen Wert begrenzt, bei dem der Transistor noch nicht überlastet wird, und der genügt, um das Flip-Flop 24 zu setzen, das von den Steuersignalen getaktet wird.

Durch das Setzen des Flip-Flops 24 wird der über einen Widerstand 29 mit dem Ausgang Q des Flip-Flops 24 verbundene Transistor 25 leitend, so daß im Falle eines Kurzschlusses der Ausgang 26 den Pegel L einnimmt. Gleichzeitig wird durch die Verbindung des Ausgangs Q des Flip-Flops 24 mit der Nicht-Und-Schaltung 10 eine weitere Zuführung der Steuersignale zum Transistor 2 solange unterbunden, bis das Steuersignal am Eingang 8 wieder einen Wechsel von Pegel L nach Pegel H macht, und damit das Flip-Flop 24 wieder zurückgesetzt wird.

In dem Baustein 1 ist ferner ein Temperatursensor 31 vorgesehen, der ein Signal Thx abgibt, welches bei Überschreiten eines zulässigen Temperaturwertes den Pegel H einnimmt. Dieses Signal wird den Oder-Schaltungen 23, 23' zugeführt und löst damit in beiden Schaltungen eine Kurzschluß-Fehlermeldung aus. Da ein gleichzeitiger Kurzschluß bei beiden Ausgängen 3, 3' äußerst unwahrscheinlich ist, kann ein angeschlossener Mikrocomputer daran erkennen, daß mit großer Sicherheit eine thermische Überlastung vorliegt.

Über einen Anschluß 32 kann der Baustein 1 mit Massepotential bzw. mit dem negativen Pol der Betriebsspannungsquelle verbunden werden. Ein Anschluß 33 dient zur Zuführung der positiven Betriebsspannung. Mit Hilfe eines weiteren Anschlusses 34 kann der Baustein für zwei verschiedene Lastbereiche umgeschaltet werden. Über einen Widerstand 35 ist der Anschluß 34 mit der positiven Betriebsspannung beaufschlagt.

Wird der Baustein 1 in einer Steuereinrichtung mit geringen Lasten verwendet, so ist der Anschluß 34 mit Massepotential verbunden. Bei Steuereinrichtungen mit hohen Lasten bleibt der Anschluß 34 ohne weitere Verbindung. Über einen nichtinvertierenden Verstärker 36 wird die bei 34 zugeführte Umschaltspannung PROG einem Steuereingang des Verstärkers 11 und Steuereingängen der Schwellwertschaltungen 13, 21 zugeführt. Über einen invertierenden Verstärker 37 gelangt die invertierte Umschaltspannung $\overline{PROG}$ zur Basis des Transistors 7. Durch die Steuerung des Verstärkers 11 ist es möglich, den Basisstrom des Transistors 2 an die jeweilige Last, also an den maximalen Strom, anzupassen. Dadurch wird bei kleineren Lasten ein unnötig hoher Basisstrom vermieden. Die Steuerung der Schwellwertschaltungen 13, 21 ermöglicht eine Anpassung der Schwellwerte an die jeweils vorhandenen Lasten. Die Umschaltung der Spannungsbegrenzung kann beispielsweise derart ausgelegt sein, daß bei Einspritzventilen, die eine relativ hohe Rückschlagspannung aufweisen, die Begrenzung bei 80 V und bei anderen Lasten bei 27 V erfolgt.

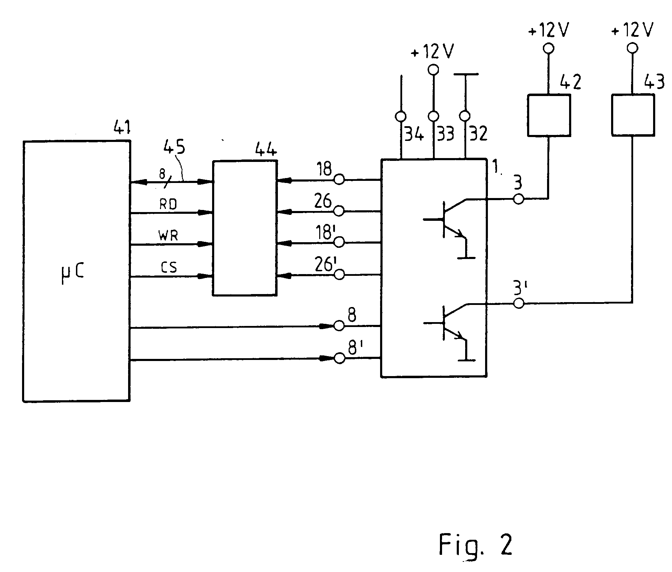

Fig. 2 zeigt Teile einer Steuereinrichtung unter Verwendung des Bausteins 1 gemäß Fig. 1. Dabei ist ein Mikrocomputer 41 vorgesehen, der Steuersignale erzeugt und über die Eingänge 8, 8' dem Baustein 1 zuführt. Die Ausgänge 3, 3' des Bausteins sind mit Einspritzventilen 42, 43 verbunden, denen ferner eine Spannung von +12 V zugeführt wird. Über Anschlüsse 33, 32 ist der Baustein an eine Betriebsspannungsquelle und an Massepotential angeschlossen. Zur Abfrage der Fehlermeldungen, die, wie im Zusammenhang mit Fig. 1 beschrieben, im Baustein 1 erzeugt werden, sind die Ausgänge 18, 26, 18', 26' mit Eingängen einer Portererweiterung 44 verbunden. Über eine Datenleitung 45 und zugehörige Steuerleitungen RD, WR und CS fragt der Computer 41 den Zustand der Ausgänge 18, 26, 18' und 26' ab. Entsprechend dem im Computer 41 abgelegten Programm können beim Vorliegen von Fehlermeldungen geeignete Schritte eingeleitet werden.

## Patentansprüche

1. Als Baustein ausgebildete Schaltungsanordnung mit mindestens einem Halbleiterschalter (2) zum Schalten einer Last, insbesondere eines Stellgliedes in Steuerungs- oder Regeleinrichtungen, bei welcher ein Umschalteingang (34) vorgesehen ist, wobei die Schaltungsanordnung in Abhängigkeit von einer dem Umschalteingang zuführbaren Umschaltspannung an verschiedene, vorzugsweise zwei verschiedene, Lastbereiche angepaßt ist, dadurch gekennzeichnet, daß Schwellwerte, bei denen eine Kurzschluß-Überwachungsschaltung (21 bis 26) und eine Leerlauf-Überwachungsschaltung (13 bis 19) ansprechen, von der Umschaltspannung abhängig sind.

2. Schaltungsanordnung nach Anspruch 1, dadurch gekennzeichnet, daß die Amplitude eines Steuersignals, das der Steuerelektrode des Halbleiterschalters (2) zuführbar ist, von der Umschaltspannung abhängig ist.

3. Schaltungsanordnung nach einem der vorhergehenden Ansprüche, dadurch gekennzeichnet, daß eine Begrenzung der Spannung am Halbleiterschalter (2) von der Umschaltspannung abhängig ist.

4. Schaltungsanordnung nach einem der vorhergehenden Ansprüche, dadurch gekennzeichnet, daß für jeweils einen Halbleiterschalter (2) eine Kurzschluß-Überwachungsschaltung (21 bis 26) und eine Leerlauf-Überwachungsschaltung (13 bis 19) mit je einem Ausgangsanschluß (26, 18) vorgesehen sind.

5. Schaltungsanordnung nach Anspruch 4, dadurch gekennzeichnet, daß bei einer pulsierenden Ansteuerung des Halbleiterschalters (2) ein Ausgangssignal der Leerlauf-Überwachungsschaltung (13 bis 19) erzeugt wird, das den zur Anzeige eines Leerlaufs vorgesehenen Wert einnimmt, wenn während einer gesamten leitenden Phase des Halbleiterschalters (2) der Strom durch den Halbleiterschalter (2) unter einem vorgegebenen Wert bleibt.

6. Schaltungsanordnung nach einem der Ansprüche 4 oder 5, dadurch gekennzeichnet, daß die Leerlauf-Überwachungsschaltung von einer ersten Schwellwertschaltung (13), einem ersten Tiefpaß (14) und einem ersten Flip-Flop (15) und die Kurzschluß-Überwachungsschaltung von einer zweiten Schwellwertschaltung (21), einem zweiten Tiefpaß (22) und einem zweiten Flip-Flop (24) gebildet ist.

7. Schaltungsanordnung nach Anspruch 6, dadurch gekennzeichnet, daß das erste Flip-Flop (15) vom Ausgangssignal des ersten Tiefpasses (14) rücksetzbar und von einem zugeführten impulsförmigen Steuersignal setzbar ist und daß ein Ausgangssignal des ersten Flip-Flops (15) zur Bildung eines Ausgangssignals der Leerlauf-Überwachungsschaltung mit dem Steuersignal verknüpft wird.

8. Schaltungsanordnung nach Anspruch 6, dadurch gekennzeichnet, daß das zweite Flip-Flop (24) vom Ausgangssignal des zweiten Tiefpasses (22) setzbar ist und von einem zugeführten impulsförmigen Steuersignal getaktet wird und daß ein Ausgangssignal des zweiten Flip-Flops (24) das Ausgangssignal der Kurzschluß-Überwachungsschaltung bildet.

9. Schaltungsanordnung nach Anspruch 8, dadurch gekennzeichnet, daß das Ausgangssignal der zweiten Schwellwertschaltung (21) die Zuführung des Steuersignals zur Steuerelektrode des Halbleiterschalters (2) steuert.

10. Schaltungsanordnung nach Anspruch 8, dadurch gekennzeichnet, daß ein weiteres Ausgangssignal des zweiten Flip-Flops (24) die Zuführung des Steuersignals zur Steuerelektrode des Halbleiterschalters (2) steuert.

11. Schaltungsanordnung nach einem der vorhergehenden Ansprüche, dadurch gekennzeichnet, daß in dem Baustein (1) ein Temperatursensor (30) vorgesehen ist, dessen Ausgangssignal die Kurzschluß-Überwachungsschaltungen (21 bis 26, 21' bis 26') derart steuert, daß bei Überschreiten einer vorgegebenen Temperatur die Ausgänge (26, 26') der Kurzschluß-Überwachungsschaltungen (21 bis 26, 21' bis 26') den für einen Kurzschluß vorgesehenen Wert ausgeben.

12. Schaltungsanordnung nach einem der vorhergehenden Ansprüche, dadurch gekennzeichnet, daß der Halbleiterschalter (2) ein Multi-Emitter-Transistor ist, wobei ein Emitter mit Masse und zwei weitere Emitter mit je einem Eingang der Kurzschluß-Überwachungsschaltung (21 bis 26) und der Leerlauf-Überwachungsschaltung (13 bis 19) verbunden sind.

**Claims**

1. Circuit arrangement which is constructed as a component with at least one semiconductor switch (2) for switching a load, in particular an actuator element in control devices or regulating devices in which a switch-over input (34) is provided, the circuit arrangement being adapted to different, preferably two different, load ranges as a function of a switch-over voltage which can be fed to the switch-over input, characterized in that threshold values at which a short-circuit monitoring circuit (21 to 26) and an open-circuit monitoring circuit (13 to 19) are triggered are dependent on the switch-over voltage.

2. Circuit arrangement according to Claim 1, characterized in that the amplitude of a control signal which can be fed to the control electrode of the semiconductor switch (2) is dependent on the switch-over voltage.

3. Circuit arrangement according to one of the preceding claims, characterized in that a limitation of the voltage at the semiconductor switch (2) is dependent on the switch-over voltage.

4. Circuit arrangement according to one of the preceding claims, characterized in that a short-circuit monitoring circuit (21 to 26) and an open-circuit monitoring circuit (13 to 19) each with an output connection (26, 18) are provided for one semiconductor switch (2) in each case.

5. Circuit arrangement according to Claim 4, characterized in that, in the case of pulsating driving of the semiconductor switch (2), an output signal of the open-circuit monitoring circuit (13 to 19) is produced, which output signal assumes the value provided for indicating an open circuit if the current through the semiconductor switch (2) remains below a prescribed value during an entire conductive phase of the semiconductor (2).

6. Circuit arrangement according to one of Claims 4 or 5, characterized in that the open-circuit monitoring circuit is formed by a first threshold value circuit (13), a first low-pass filter (14) and a first flip-flop (15) and the short-circuit monitoring circuit is formed by a second threshold value circuit (21), a second low-pass filter (22) and a second flip-flop (24).

7. Circuit arrangement according to Claim 6, characterized in that the first flip-flop (15) can be reset by the output signal of the first low-pas filter (14) and can be set by a fed-in, pulse-shaped control signal, and in that an output signal of the first flip-flop (15) is logically connected to the control signal in order to form an output signal of the open-circuit monitoring circuit.

8. Circuit arrangement according to Claim 6, characterized in that the second flip-flop (24) can be set by the output signal of the second low-pass filter (22) and is clocked by a fed-in, pulse-shaped control signal, and in that an output signal of the second flip-flop (24) forms the output signal of the short-circuit monitoring circuit.

9. Circuit arrangement according to Claim 8, characterized in that the output signal of the second threshold value circuit (21) controls the feeding of the control signal to the control electrode of the semiconductor switch (2).

10. Circuit arrangement according to Claim 8, characterized in that a further output signal of the second flip-flop (24) controls the feeding of the control signal to the control electrode of the semiconductor switch (2).

11. Circuit arrangement according to one of the preceding claims, characterized in that a temperature sensor (30) is provided in the component (1), the output signal of which sensor controls the short-circuit monitoring circuits (21 to 26, 21' to 26') in such a way that when a prescribed temperature is exceeded the outputs (26, 26') of the short-circuit monitoring circuits (21 to 26, 21' to 26') output the value provided for a short-circuit.

12. Circuit arrangement according to one of the preceding claims, characterized in that the semiconductor switch (2) is a multi-emitter transistor, one emitter being connected to earth and two further emitters being connected to one input each of the short-circuit monitoring circuit (21 to 26) and of the open-circuit monitoring circuit (13 to 19).

## Revendications

1. Circuit réalisé sous la forme d'un composant et présentant au moins un commutateur (2) à semi-conducteurs pour commuter une charge, en particulier un organe de manoeuvre dans des dispositifs de commande ou de régulation, circuit dans lequel une entrée de commutation (34) est prévue, ledit circuit étant adapté, en fonction d'une tension de commutation pouvant être appliquée à l'entrée de commutation, à différentes, de préférence à deux plages de charges différentes, caractérisé par le fait que des valeurs de seuil, en présence desquelles un circuit (21 à 26) de surveillance de court-circuitage et un circuit (13 à 19) de surveillance de marche à vide réagissent, sont dépendantes de la tension de commutation.

2. Circuit selon la revendication 1, caractérisé par le fait que l'amplitude d'un signal de commande, pouvant être appliqué à l'électrode de commande du commutateur (2) à semi-conducteurs, dépend de la tension de commutation.

3. Circuit selon l'une des revendications précédentes, caractérisé par le fait qu'une limitation de la tension appliquée au commutateur (2) à semi-conducteurs dépend de la tension de commutation.

4. Circuit selon l'une des revendications précédentes, caractérisé par la présence, pour un commutateur respectif (2) à semi-conducteurs, d'un circuit (21 à 26) de surveillance de court-circuitage et d'un circuit (13 à 19) de surveillance de marche à vide, comportant chacun un raccord de sortie (26, 18).

5. Circuit selon la revendication 4, caractérisé par le fait que, dans le cas d'une activation pulsatoire du commutateur (2) à semi-conducteurs, le circuit (13 à 19) de surveillance de marche à vide engendre un signal de sortie qui prend la valeur prévue pour afficher une marche à vide lorsque, durant une phase de conduction intégrale du commutateur (2) à semi-conducteurs, le courant circulant par ledit commutateur (2) à semi-conducteurs demeure en deçà d'une valeur préétablie.

6. Circuit selon l'une des revendications 4 ou 5, caractérisé par le fait que le circuit de surveillance de marche à vide est formé d'un premier circuit (13) à valeurs de seuil, d'un premier passe-bas (14) et d'une première bascule (15), et le circuit de surveillance de court-circuitage est formé d'un second circuit (21) à valeurs de seuil, d'un second passe-bas (22) et d'une seconde bascule (24).

7. Circuit selon la revendication 6, caractérisé par le fait que la première bascule (15) peut être remise à zéro par le signal de sortie du premier passe-bas (14) et peut être réglée par un signal de commande appliqué en forme d'impulsion ; et par le fait qu'un signal de sortie de la première bascule (15) est combiné au signal de commande, afin de former un signal de sortie du circuit de surveillance de marche à vide.

8. Circuit selon la revendication 6, caractérisé par le fait que la seconde bascule (24) peut être réglée par le signal de sortie du second passe-bas (22) et est synchronisée par un signal de commande appliqué en forme d'impulsion ; et par le fait qu'un signal de sortie de la seconde bascule (24) forme le signal de sortie du circuit de surveillance de court-circuitage.

9. Circuit selon la revendication 8, caractérisé par le fait que le signal de sortie du second circuit (21) à valeurs de seuil pilote l'application du signal de commande à l'électrode de commande du commutateur (2) à semi-conducteurs.

10. Circuit selon la revendication 8, caractérisé par le fait qu'un signal additionnel de sortie de la seconde bascule (24) pilote l'application du signal de commande à l'électrode de commande du commutateur (2) à semi-conducteurs.

11. Circuit selon l'une des revendications précédentes, caractérisé par le fait qu'il est prévu, dans le composant (1), une sonde thermométrique (30) dont le signal de sortie commande les circuits (21 à 26, 21' à 26') de surveillance de court-circuitage de façon telle que, lors du dépassement d'une température préétablie, les sorties (26, 26') desdits circuits (21 à 26, 21' à 26') de surveillance de court-circuitage délivrent la valeur prévue pour un court-circuit.

12. Circuit selon l'une des revendications précédentes, caractérisé par le fait que le commutateur (2) à semi-conducteurs est un transistor à plusieurs émetteurs, un émetteur étant raccordé à la masse, et deux autres émetteurs étant raccordés à une entrée respective du circuit (21 à 26) de surveillance de court-circuitage et du circuit (13 à 19) de surveillance de marche à vide.

Fig. 1

Fig. 2